# EUROPEAN PATENT SPECIFICATION

(11) **EP 2 765 596 B1**
(45) Date of publication and mention of the grant of the patent: **11.07.2018**
(21) Application number: 14153892.6
(22) Date of filing: 04.02.2014
(51) Int. Cl.: H01L 21/265, H01L 21/67, H01J 37/317

(54) **Ion implantation at high temperature surface equilibrium conditions**
Ionenimplantation bei Hochtemperaturoberflächen-Gleichgewichtsbedingungen
Implantation d'ions à des conditions d'équilibre de surface à haute température

(30) Priority: 12.02.2013 US 201361763895 P; 07.03.2013 US 201313788318; 31.01.2014 US 201414170293
(43) Date of publication of application: 13.08.2014
(73) Proprietor: Infineon Technologies Americas Corp., El Segundo, CA 90245 (US)
(72) Inventor: Briere, Michael A., Scottsdale, AZ 85266 (US)
(74) Representative: JENSEN & SON

(56) References cited:
- WO-A1-2009/029329
- WO-A2-2010/051266
- US-A1- 2004 107 906
- US-A1- 2005 136 627
- US-A1- 2008 315 129
- US-A1- 2010 171 126

## Description

### BACKGROUND

The present application claims the benefit of and priority to a provisional application entitled "Ion Implantation at High Temperature Surface Equilibrium Conditions," Serial No. 61/763,895 filed on February 12, 2013. In addition, the present application is a continuation-in-part of application Serial No. 13/788,318, entitled "Method and Apparatus for Growing a III-Nitride Layer," filed on March 7, 2013, which is itself a continuation of application Serial No. 12/006,562, entitled "Ion Implanting While Growing a III-Nitride Layer," filed on January 3, 2008, and issued as U.S. Patent Number 8,395,132 on March 12, 2013, which in turn claims priority to provisional application Serial No. 60/937,101 filed on June 25, 2007. The disclosures in the above-referenced patent and patent applications are hereby incorporated fully by reference into the present application. Moreover, the present application claims priority to each one of the patent and patent applications identified above.

### I. DEFINITION

As used herein, the phrase "group III-V" refers to a compound semiconductor including at least one group III element and at least one group V element. By way of example, a group III-V semiconductor may take the form of a III-Nitride semiconductor. "III-Nitride", or "III-N", refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(1-x-y)}AsₐP_{b}N_{(1-a-b)}), for example. III-Nitride also refers generally to any polarity including but not limited to Ga-polar, N-polar, semi-polar, or non-polar crystal orientations. A III-Nitride material may also include either the Wurtzitic, Zincblende, or mixed polytypes, and may include single-crystal, monocrystalline, polycrystalline, or amorphous structures. Gallium nitride or GaN, as used herein, refers to a III-Nitride compound semiconductor wherein the group III element or elements include some or a substantial amount of gallium, but may also include other group III elements in addition to gallium.

### II. BACKGROUND ART

III-Nitride materials are semiconductor compounds that have relatively wide direct bandgaps and can have strong piezoelectric polarizations, which can enable high breakdown fields, high saturation velocities, and the creation of two-dimensional electron gases (2DEGs), when combined as stacked layers. As a result, III-Nitride materials are suitable for use in many microelectronic applications as field-effect transistors (FETs), including heterostructure FETs (HFETs) such as high electron mobility transistors (HEMTs).

However, one of the challenges posed by III-Nitride semiconductor device fabrication is doping a III-Nitride semiconductor body without compromising its stoichiometric integrity. Specifically, it is known that at high temperatures, for example temperatures greater than approximately 800 °C, nitrogen may escape from the III-Nitride surface, resulting in its decomposition. A conventional approach to address this problem utilizes a technique for growing the dopants into the III-Nitride body as it is formed, rather than performing ion implantation. A significant drawback of that approach, however, is that it results in formation of relatively homogenously doped layers within the III-Nitride body. Consequently, differential doping is typically achieved only vertically, so that spatially confined doping in the lateral direction may not be achieved directly through such growth except through the use of relatively complex and expensive etch and redeposition/regrowth methods.

WO 2010/051266 A1 describes a method comprising situating a semiconductor body in a surface equilibrium chamber establishing a gas pressure heating said III-Nitride semiconductor body to an elevated implantation temperature in said surface equilibrium chamber while substantially maintaining said gas pressure, "temperature may be maintained at between about 10 degrees Celsius and about 500 degrees Celsius"; implanting said III-Nitride semiconductor body in said surface equilibrium chamber at said elevated implantation temperature while substantially maintaining said gas pressure.

WO 2009/029329 A discloses a high temperature (e.g. 650°C) ion beam implantation process for a III-Nitride semiconductor body.

Document US2008/0315129 A1 discloses a method that includes implantation of dopants while a III-nitride body is being grown on a substrate.

### SUMMARY

The present disclosure is directed to ion implantation at high temperature surface equilibrium conditions, substantially as shown in and/or described in connection with at least one of the figures. A method is provided which comprises situating a III-Nitride semiconductor body in a surface equilibrium chamber configured to prevent an escape of nitrogen from said III-Nitride semiconductor body during implantation of said III-Nitride semiconductor body, establishing a gas pressure greater than or equal to a surface equilibrium pressure sufficient to prevent said escape of nitrogen from said III-Nitride semiconductor body, heating said III-Nitride semiconductor body to an implantation temperature in a range of 500°C to 1100°C in said surface equilibrium chamber while substantially maintaining said gas pressure above an exposed surface of said III-Nitride semiconductor body, implanting said III-Nitride semiconductor body in said surface equilibrium chamber at said elevated implantation temperature while substantially maintaining said gas pressure in a range between 1.0 and 1000 mTorr, wherein said implanting is performed using an ion implanter interfacing with said surface equilibrium chamber.

### BRIEF DESCRIPTION OF THE DRAWINGS

Figure 1 shows a cross-sectional view of an implantation chamber for performing ion implantation at high temperature surface equilibrium conditions, according to one implementation.
Figure 2 shows a cross-sectional view of an implantation chamber for performing ion implantation at high temperature surface equilibrium conditions, according to another implementation.
Figure 3 shows a flowchart presenting an exemplary method for performing ion implantation at high temperature surface equilibrium conditions.
Figure 4 shows a cross-sectional representation of a P-N junction formed in a III-Nitride semiconductor body as a result of ion implantation at high temperature surface equilibrium conditions, according to one implementation.
Figure 5A shows a cross-sectional representation of a buried P type region formed in a III-Nitride semiconductor body as a result of ion implantation at high temperature surface equilibrium conditions, according to one implementation.
Figure 5B shows a cross-sectional representation of buried N type region formed in a III-Nitride semiconductor body as a result of ion implantation at high temperature surface equilibrium conditions, according to another implementation.
Figure 5C shows a cross-sectional representation of buried P type and N type regions formed in a III-Nitride semiconductor body as a result of ion implantation at high temperature surface equilibrium conditions, according to yet another implementation.
Figure 6A shows a cross-sectional representation of vertically stacked P type and N type regions formed in a III-Nitride semiconductor body as a result of ion implantation at high temperature surface equilibrium conditions, according to one implementation.
Figure 6B shows a cross-sectional representation of vertically stacked and buried P type and N type regions formed in a III-Nitride semiconductor body as a result of ion implantation at high temperature surface equilibrium conditions, according to another implementation.
Figure 6C shows a cross-sectional representation of vertically stacked P type and N type regions formed in a III-Nitride semiconductor body as a result of ion implantation at high temperature surface equilibrium conditions, according to yet another implementation.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

The present application is directed to a method and system for ion implantation of a III-Nitride semiconductor body. As disclosed herein, ion implantation of the III-Nitride semiconductor body may be performed at elevated temperatures and equilibrium pressure in an implantation chamber. For example, in some implementations, ion implantation may be performed in the surface and near surface regions of the III-Nitride semiconductor body. In some implementations, the present solution can eliminate or reduce the requirements for post implant high temperature anneals, required for dopant activation, that are typically a necessity in the conventional art. Moreover, the present solution may provide a system enabling dopant activation through in-situ annealing of the implant damage and activation of the dopants, while avoiding the decomposition of the III-Nitride semiconductor body stoichiometry.

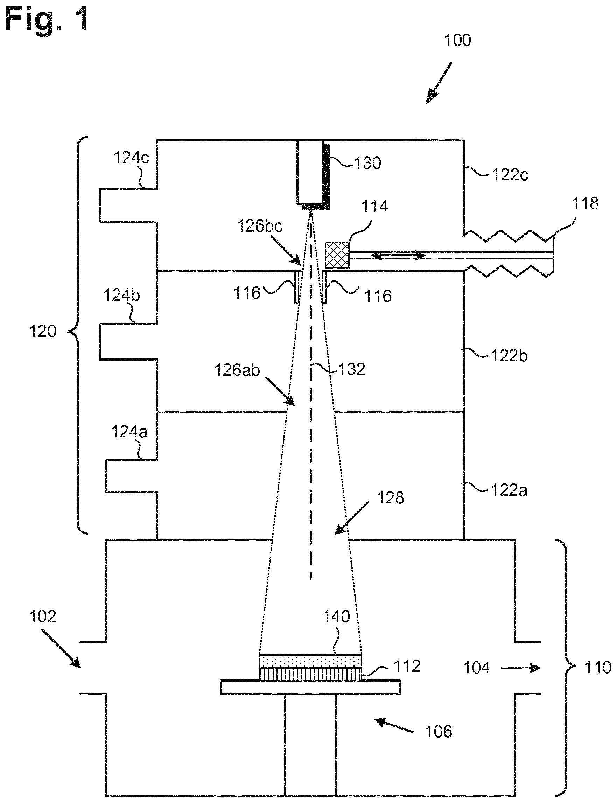

Figure 1 shows a cross-sectional diagram of implantation chamber 100 for ion implantation at high temperature surface equilibrium conditions, according to one implementation. As shown in Figure 1, implantation chamber 100 includes surface equilibrium chamber 110, ion implanter 130, and transition chamber 120 interfacing ion implanter 130 with surface equilibrium chamber 110. As further shown in Figure 1, transition chamber 120 includes differential pressure cells 122a, 122b, and 122c. Also shown in Figure 1 is III-Nitride semiconductor body 140, such as a gallium nitride (GaN) body, for example, grown over support substrate 112. Support substrate 112 may be any suitable substrate material for the growth of III-Nitride semiconductor body, and may include silicon, silicon carbide, sapphire, and when available, a native III-Nitride semiconductor substrate, for example.

According to the present implementation, surface equilibrium chamber 110 includes platform 106, which may be a rotating platform or a controllably moveable platform, for example, on which support substrate 112 and III-Nitride semiconductor body 140 may be placed during ion implantation of III-Nitride semiconductor body 140. As shown in Figure 1, surface equilibrium chamber 110 is equipped with intake port 102 to allow for the entry of a gas or gases for establishing surface equilibrium conditions for III-Nitride semiconductor body 140, as well as output port 104 for the removal of such gas or gases. Surface equilibrium chamber 110 is designed such that the equilibrium pressure within surface equilibrium chamber 110 is controlled to sustain a partial vacuum range of approximately one to approximately one thousand millitorr (1.0 - 1000 mTorr). 1 mTorr is about 0.1333 Pa. In one implementation, for example, surface equilibrium chamber 110 may be controlled to sustain a partial vacuum range of approximately 100 mTorr.

Ion implanter 130 may provide ions for implantation into III-Nitride semiconductor body 140 as ion beam 132, and may perform selective implantation of portions of III-Nitride semiconductor body 140. In general, ion implanter 130 is an apparatus that produces and may focus ion beam 132 of substantially identical ions having a well controlled velocity and mass from a solid or gaseous source material. In some implementations, ion beam 132 can be a focused ion beam with the ability to write or raster over the surface of III-Nitride semiconductor body 140, such as by being steered over the surface of III-Nitride semiconductor body 140. In other implementations, ion beam 132 can be a wide area focused ion beam allowing for blanket ion implantation, or implantation using stencil masks or sacrificial mask layers over a larger area of III-Nitride semiconductor body 140. Such masks may include common materials well known in the art, and may be organically based, or may be formed of photo-resist, silicon dioxide, or silicon nitride, for example.

Transition chamber 120 may be utilized to provide a suitable environment, such as a low pressure or high vacuum environment, for ion implanter 130 and its interaction with surface equilibrium chamber 110. Transition chamber 120 serves to interface ion implanter 130 with surface equilibrium chamber 110, which is configured to provide surface equilibrium conditions for III-Nitride semiconductor body 140 during ion implantation.

In order to enable interface of ion implanter 130 with surface equilibrium chamber 110, differential pumping may be used to evacuate transition chamber 120. As shown in Figure 1, in one implementation, transition chamber 120 may include several differential pressure cells 122a, 122b, and 122c. Each differential pressure cell 122a, 122b, and 122c is in communication with an adjacent differential pressure cell through respective apertures 126ab and 126bc. It is noted that ion beam 132 passes through apertures 126bc and 126ab to travel through transition chamber 120, which interfaces ion implanter 130 with surface equilibrium chamber 110 through linking aperture 128. Differential pressure cells 122a, 122b, and 122c may be selectably evacuated using respective pumping apertures 124a, 124b, and 124c.

As further shown in Figure 1, in some implementations, differential pressure cell 122c of transition chamber 120 may also include Faraday cup 114. When present, Faraday cup 114 may be linked to a current meter (not shown in Figure 1) to measure the implant dosage of ions being received from ion implanter 130. In one implementation, Faraday cup 114 may be attached to bellows 118 (or another type of mechanical linear actuator used in vacuum technology) to allow Faraday cup 114 to be moved into and out of the path of ion beam 132. It is noted that, in some implementations, it may be advantageous or desirable to situate Faraday cup 114 within differential pressure cell 122c to provide for a more accurate reading of the ion beam flux prior to possible neutralization of the ions. Such ion neutralization may occur as ion beam 132 passes through differential pressure cells 122a, 122b, and 122c, and surface equilibrium chamber 110. However, in one implementation, Faraday cup 114 may be incorporated into aperture 126bc.

It is noted that Faraday cup 114 may be periodically positioned in the path of ion beam 132 (e.g., approximately 1% of the time) in order to measure the implant dosage being directed at III-Nitride semiconductor body 140, thereby enabling estimation of the concentration of ions implanted into III-Nitride semiconductor body 140. This periodic positioning may be accomplished by actuation of bellows 118 at a predetermined periodicity. As an alternative example, Faraday cup 114 may be mounted on a rotating plate or wheel or armature (not shown in Figure 1) within differential pressure cell 122c, such that Faraday cup 114 rotates under ion beam 132 at a predetermined rate (e.g., 1% of the implant time).

Transistion chamber 120 according to the present implementation may further include deflection plates, such as deflection plates 116, positioned inside differential pressure cell 122b, for example, near aperture 126bc. Deflection plates 116 may be used to change the direction of ion beam 132 entering surface equilibrium chamber 110, for example, so as to steer ion beam 132 over the surface of III-Nitride semiconductor body 140.

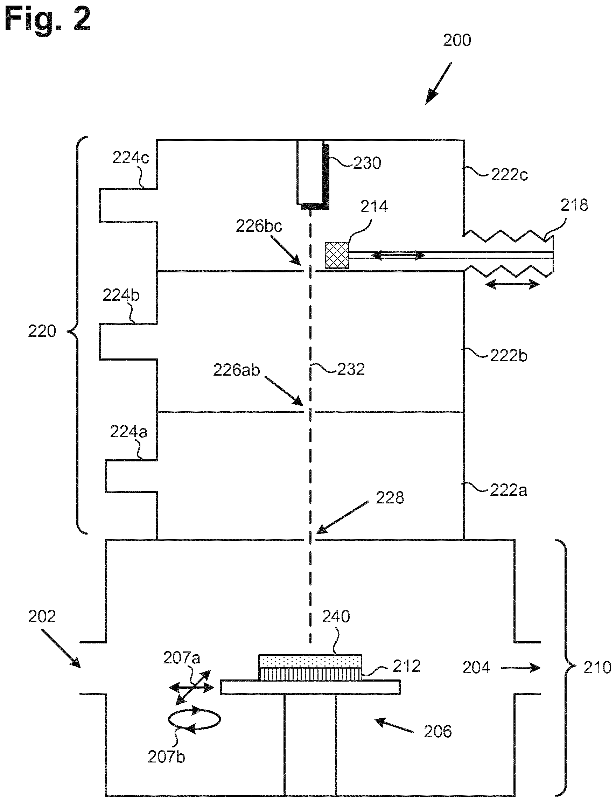

Referring to Figure 2, Figure 2 shows a cross-sectional view of implantation chamber 200 for performing ion implantation at high temperature surface equilibrium conditions, according to another implementation. Implantation chamber 200 includes surface equilibrium chamber 210, ion implanter 230, and transition chamber 220 interfacing ion implanter 230 with surface equilibrium chamber 210. Transition chamber 220 includes differential pressure cells 222a, 222b, and 222c having respective differential pumping apertures 224a, 224b, and 224c. Surface equilibrim chamber 210 includes intake port 202, output port 204, and platform 206. As shown in Figure 2, III-Nitride semiconductor body 240 and support substrate 212 are situated on platform 206. Also shown in Figure 2 are Faraday cup 214, bellows 218, ion beam 232, appertures 226ab and 226bc, and linking aperture 228. Implantation chamber 200 including surface equilibrium chamber 210, ion implanter 230, and transition chamber 220 corresponds in general to implantation chamber 100 including surface equilibrium chamber 110, ion implanter 130, and transition chamber 120, in Figure 1.

According to the exemplary implementation shown in Figure 2, ion beam 232 may be a focused ion beam produced so as to impinge upon III-Nitride semiconductor body 240 in the absence of ion beam steering, provided, for example, by deflection plates 116, in Figure 1. Rather, in the present implementation, platform 206 is shown as a controllably moveable platform, such as a rotating platform for example, as indicated by linear displacement lines 207a and/or rotational arrows 207b. In this implementation, aperture 226ab and linking aperture 228 may be made much smaller, and the pressure in transition chamber 220 can more easily reduced, than in the implementation shown in Figure 1.

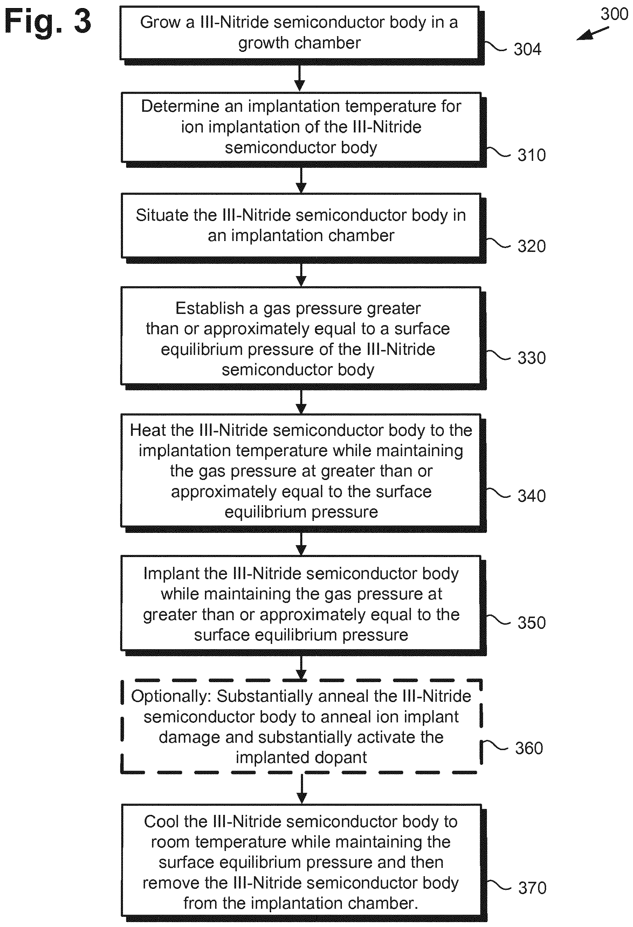

The operation of exemplary implantation chambers 100 and 200 will be further described by reference to flowchart 300, in Figure 3, which outlines an exemplary method for performing ion implantation of a III-Nitride semiconductor body at high temperature surface equilibrium conditions. It is noted that certain details and features have been left out of flowchart 300 that are apparent to a person of ordinary skill in the art.

Referring to Figure 3 with continuing reference to Figures 1 and 2, flowchart 300 begins with growing III-Nitride semiconductor body 140/240 in a growth chamber (304). III-Nitride semiconductor body 140/240 may be grown over support substrate 112/212, which may be any suitable substrate for III-Nitride growth, such as a silicon, silicon carbide (SiC), or aluminum oxide (Al₂O₃) substrate, or a native III-Nitride substrate, for example. It is noted that as used herein, the term silicon substrate refers to a semiconductor substrate that includes at least one layer of silicon. This includes silicon based composite substrates such as silicon-on-insulator (SOI) and separation by implantation of oxygen (SIMOX) process substrates, as well as silicon on sapphire (SOS) substrates for example. Such a silicon substrate may also contain silicon devices and vias formed on or within the silicon substrate.

Growth of III-Nitride semiconductor body 140/240 may occur in implantation chamber 100/200. In some implementations, surface equilibrium chamber 110/210 may have been configured as a growth chamber 110/210 during a growth phase of III-Nitride semiconductor body 140/240. That is to say, chamber 110/210 may be configurable first as growth chamber 110/210 and subsequently as surface equilibrium chamber 110/210 during fabrication and processing of III-Nitride semiconductor body 140/240. In other implementations, however, III-Nitride semiconductor body 140/240 may be grown in a growth chamber apart from ion implantation chamber 100/200.

Growth of III-Nitride semiconductor body 140/240 may be performed using any suitable growth technique, such as metalorganic chemical vapor deposition (MOCVD) or molecular-beam epitaxy (MBE), for example. Growth of III-Nitride semiconductor body 140/240 may occur in any suitable atmospheric and thermal environment for growing III-Nitride materials, such as in the presence of nitrogen gas or a nitrogen precursor gas like ammonia, as well as additional reactant gases such as trimethylgallium (TMG) and trimethylaluminum (TMA), for instance.

In one implementation, III-Nitride semiconductor body 140/240 may be grown using the MOCVD technique and may be deposited on support substrate 112/212, which may be a silicon substrate. As a result, in some implementations, III-Nitride semiconductor body 140/240 may include an amorphous silicon aluminum nitride based layer, one or more aluminum nitride (AlN) nucleation layers, compositionally graded transition layers, one or more strain absorbing transition interlayer modules, a buffer layer, a channel layer, an AlN spacer layer, one or more barrier layers, and/or one or more III-Nitride capping layers.

Flowchart 300 continues with determining an implantation temperature for ion implantation of III-Nitride semiconductor body 140/240 (310). More generally, however, such a determination may include identifying additional implantation conditions for ion implantation of III-Nitride semiconductor body 140/240. In addition to determination of implantation temperature, implantation conditions to be identified may include a number of other variables, such as the ion species to be implanted, the desired depth of implantation, and the gas species used in the surface equilibration chamber 110/210 to be utilized during implantation, for example. In addition, implantation conditions may include whether ion beam 132/232 is to be a focused ion beam with the ability to write or raster over the surface of III-Nitride semiconductor body 140/240, or whether ion beam 132/232 is to be a wide area defocused ion beam allowing for a blanket, stenciled, or sacrificially masked, ion implantation over a larger area of III-Nitride semiconductor body 140/240.

Flowchart 300 continues with situating III-Nitride semiconductor body 140/240 in implantation chamber 100/200 (320). As shown in Figures 1 and 2, III-Nitride semiconductor body 140/240 and support substrate 112/212 may be situated in surface equilibrium chamber 110/210 of implantation chamber 100/200. As noted above, III-Nitride semiconductor body 140/240 may have been grown over support substrate 112/212 prior to its being situated in surface equilibrium chamber 110/210 of implantation chamber 100/200.

III-Nitride semiconductor body 140/240 may correspond to a body formed from any one or more suitable III-Nitride semiconductor materials, as are described in the definition section above. Typically, the only constraint placed upon the composition of III-Nitride semiconductor body 140/240 is that it include at least one layer of III-Nitride semiconductor material. In some implementations, III-Nitride semiconductor body 140/240 may include a first III-Nitride semiconductor layer and a second III-Nitride semiconductor layer formed over the first III-Nitride semiconductor layer, for example, wherein the second III-Nitride semiconductor layer includes a III-Nitride semiconductor having a wider band gap than the III-Nitride semiconductor forming the first III-Nitride semiconductor layer.

As a specific example, III-Nitride semiconductor body 140/240 may include a heterojunction formed by the interface of a GaN channel layer and an aluminum gallium nitride (AlGaN) barrier layer formed over the GaN channel layer. Other examples of III-Nitride semiconductor bodies corresponding to III-Nitride semiconductor body 140/240 include commonly used epilayers found within the structures of microelectronic and optoelectronic III-Nitride devices including transistors, diodes, light-emitting diodes (LEDs), laser diodes, detectors, and sensors.

Flowchart 300 continues with establishing a gas pressure (i.e., gas overpressure) greater than or approximately equal to a surface equilibrium pressure of III-Nitride semiconductor body 140/240 (330). The gas pressure may be established within implantation chamber 100/200, using surface equilibrium chamber 110/210, based on the previously identified implantation conditions and the material composition of III-Nitride semiconductor body 140/240, typically within the partial vacuum range of about 1.0 - 1000 mTorr. Establishing the desired gas pressure may be accomplished by controlling the gas pressure within surface equilibrium chamber 110/210 through use of intake port 102/202 and output port 104/204.

The source gas or gases for establishing the gas pressure at a surface of III-Nitride semiconductor body 140/240 may be selected from any suitable nitrogen containing gas, such as nitrogen gas or ammonia, for example. The specific gas pressure required to prevent decomposition of III-Nitride semiconductor body 140/240 is dependent on factors such as the composition of the surface layer of III-Nitride semiconductor body 140/240, the temperature of III-Nitride semiconductor body 140/240, and the specific gas species being utilized. As a result, the gas pressure required will change with the temperature of III-Nitride semiconductor body 140/240, and the apparatus will be required to adjust the pressure so as to maintain the equilibrium condition and prevent decomposition of at a surface of III-Nitride semiconductor body 140/240.

Flowchart 300 continues with heating III-Nitride semiconductor body 140/240 to the implantation temperature while maintaining the gas pressure, or overpressure, at greater than or approximately equal to the surface equilibrium pressure of III-Nitride semiconductor body 140/240 (340). One of the advantageous features of the present solution is that III-Nitride semiconductor body 140/240 may be heated to an elevated implantation temperature while the gas pressure within surface equilibrium chamber 110/210 is controlled such that a surface layer of III-Nitride semiconductor body 140/240 does not decompose. For example, III-Nitride semiconductor body 140/240 may be heated to an elevated implantation temperature in a range from approximately five hundred degrees Centigrad (500 °C) to approximately eleven hundred degrees Centigrade (1100 °C).

According to some implementations it may be advantageous or desirable to perform implantation at an elevated implantation temperature greater than approximately 600 °C, while in other implementations it may be advantageous or desirable to perform implantation at an elevated implantation temperature greater than approximately 800 °C. Moreover, in some implementations, it may be advantageous or desireable to perform implantation at an elevated implantation temperature that is greater than a temperature used for growth of III-Nitride semiconductor body 140/240.

It is noted that although in the exemplary implementation disclosed by reference to flowchart 300, III-Nitride semiconductor body 140/240 is described as being situated in implantation chamber 100/200 before establishment of the implantation temperature, including heating of platform 106/206, that is only one possibility. In other implementations, the implantation temperature may be established and platform 106/206 of implantation chamber 100/200 may be preheated to or near the implantation temperature before III-Nitride semiconductor body 140/240 is situated therein.

Flowchart 300 continues with implanting III-Nitride semiconductor body 140/240 in implantation chamber 100/200 while substantially maintaining the gas pressure above the exposed surface of III-Nitride semiconductor body 140/240 at greater than or approximately equal to the surface equilibrium pressure of III-Nitride semiconductor body 140/240 (350). Substantially maintaining the gas pressure at greater than or approximately equal to the surface equilibrium pressure of III-Nitride semiconductor body 140/240 may be performed using surface equilibrium chamber 110/210 of implantation chamber 100/200.

Implantation may be performed using ion implanter 130/230 interfacing with surface equilibrium chamber 110/210, and may result in any desired ion species being implanted into III-Nitride semiconductor body 140/240. Thus, N type dopant ion, such as silicon (Si) ions, and/or P type dopant ions, such as magnesium (Mg) ions, for example, may be implanted into III-Nitride semiconductor body 140/240.

In some implementations, the implantation conditions may include use of one or more stencils to form corresponding one or more spatially confined implantation regions at or beneath the surface of III-Nitride semiconductor body 140/240. Moreover, in still other implementations, implantation may include steering of ion beam 132/232, or movement of III-Nitride semiconductor body 140/240, during implantation so as to produce one or more spatially confined implantation regions at or beneath the surface of III-Nitride semiconductor body 140/240. For example, movement of III-Nitride semiconductor body 140/240 during implantation may be achieved through controlled movement of platform 106/206. Where III-Nitride semiconductor body 140/240 has been grown undoped, for example, N type doping and P type doping may both be performed, resulting in formation of a spatially confined N type region laterally adjacent a spatially confined P type region in III-Nitride semiconductor body 140/240.

In some implementations, relatively low energy surface implantation of III-Nitride semiconductor body 140/240 may be advantageous or desirable, utilizing implantation energies of less than approximately 100 keV, for example. That is to say, in some implementations, relatively low implantation energies may be used in order to implant dopant ions near the surface of III-Nitride semiconductor body 140/240. In other implementations, however, deeper penetration into III-Nitride semiconductor body 140/240 may be desired, so that higher implantation energies may be employed. Using the solution disclosed herein, III-Nitride semiconductor body 140/240 can be doped to any reasonably achievable concentration, for example, to a concentration from approximately 10¹¹/cm² to approximately 10¹⁹/cm².

Flowchart 300 continues with optionally performing a substantial anneal of III-Nitride semiconductor body 140/240 to anneal ion implantation damage and substantially activate the implanted dopant(s) (360). During such an optional process, the temperature of implanted III-Nitride semiconductor body 140/240 may be adjusted to an appropriate annealing temperature to substantially anneal any damage that may have occurred to the III-Nitride crystal structure from the impinging high energy ions, as well as to substantially electrically activate the implanted dopants. That is to say, the method of flowchart 300 may include annealing III-Nitride semiconductor body 140/240 in-situ at elevated temperature post implantation to achieve substantial dopant activation.

Flowchart 300 may conclude with cooling down the III-Nitride body, for example to approximately room temperature, while maintaining the surface equilibrium pressure (370). Once the III-Nitride body is cooled to the desired temperature, the III-Nitride body may be removed from the implant chamber.

As noted above, one of the advantages provided by the solution disclosed herein is that the gas pressure within surface equilibrium chamber 110/210 is substantially maintained during implantation of III-Nitride semiconductor body 140/240. Substantially maintaining the gas pressure during implantation substantially prevents decomposition of III-Nitride semiconductor body 140/240 during implantation, despite its being exposed to an elevated implantation temperature. Consequently, the structural and stoichiometric properties of III-Nitride semiconductor body 140/240 can by preserved during implantation.

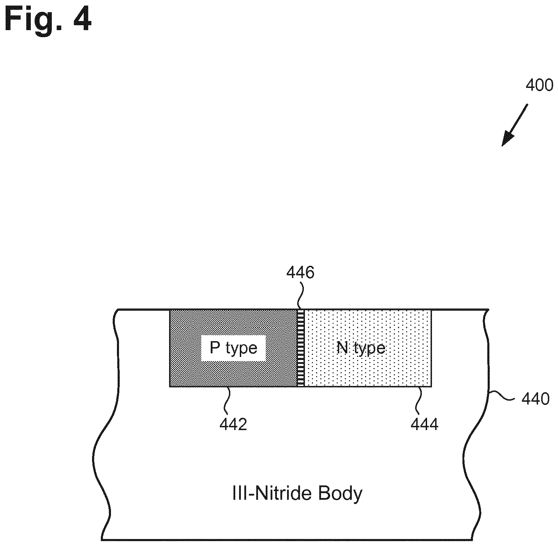

Some of the advantages resulting from the solution disclosed in the present application are depicted in Figures 4, 5A, 5B, 5C, 6A, 6B, and 6C. Referring first to Figure 4, Figure 4 shows a cross-sectional representation of a P-N junction formed in a III-Nitride semiconductor body as a result of ion implantation at high temperature surface equilibrium conditions, according to one implementation. Structure 400, in Figure 4, includes P type region 442 and N type region 444 formed in III-Nitride semiconductor body 440. III-Nitride semiconductor body 440 corresponds in general to III-Nitride semiconductor body 140/240, shown in Figure 1/2, and may share any of the characteristics attributed to that corresponding feature, above.

As shown in Figure 4, both P type region 442 and N type region 444 are spatially confined within III-Nitride semiconductor body 440, and have been selectively formed so as to be laterally adjacent one another. Moreover, spatially confined P type region 442 and spatially confined N type region 444 have been advantageously implanted to be laterally spatially confined and adjoining within III-Nitride body 440 so as to produce P-N junction 446 at their interface/overlap. Structure 400 may be utilized in the implementation of a diode, for example, or a portion of a bipolar junction transistor fabricated in III-Nitride body 440.

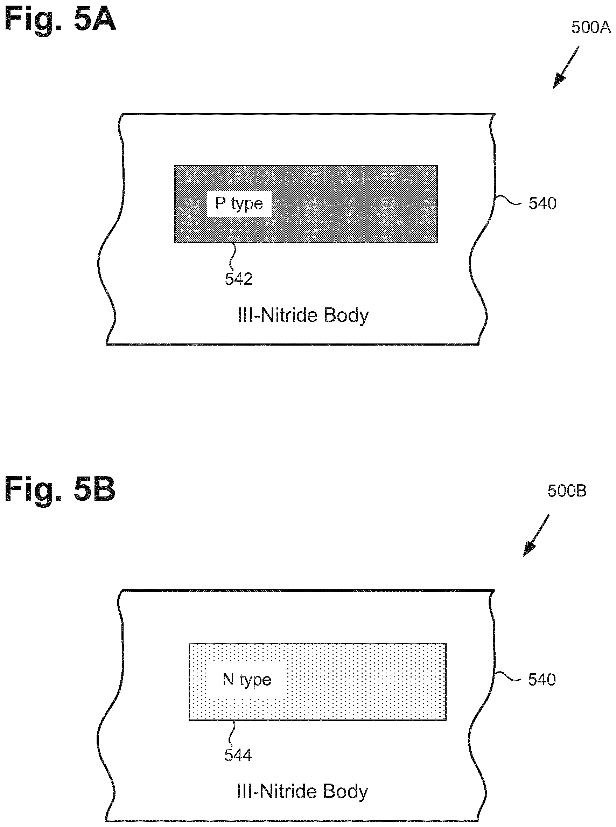

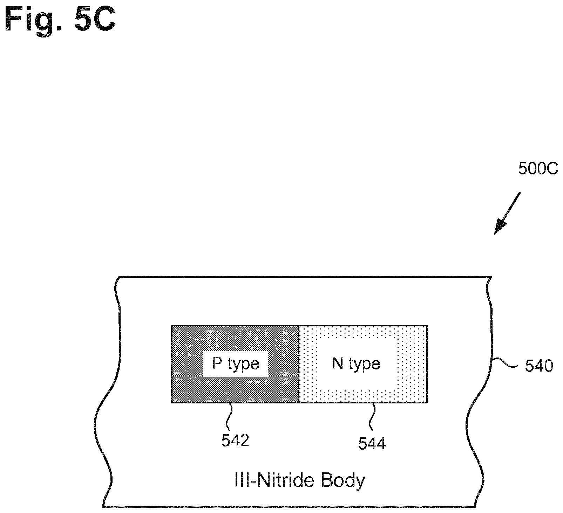

Moving to Figures 5A, 5B, and 5C, Figures 5A, 5B, and 5C show respective cross-sectional representations of buried P type and/or N type regions formed in a III-Nitride semiconductor body as a result of ion implantation at high temperature surface equilibrium conditions, according to various implementations. Structure 500A, in Figure 5A, includes spatially confined P type region 542 formed in III-Nitride semiconductor body 540. III-Nitride semiconductor body 540 corresponds in general to III-Nitride semiconductor body 140/240, shown in Figure 1/2, and may share any of the characteristics attributed to that corresponding feature, above. As shown in Figure 5A, P type region 542 is spatially confined within III-Nitride semiconductor body 540 and is buried to a predetermined depth beneath a top surface of III-Nitride semiconductor body 540.

Continuing to Figure 5B, structure 500B includes spatially confined N type region 544 formed in III-Nitride semiconductor body 540. As shown in Figure 5B, N type region 544 is spatially confined within III-Nitride semiconductor body 540 and is buried to a predetermined depth beneath the top surface of III-Nitride semiconductor body 540.

Referring to Figure 5C, structure 500C includes spatially confined P type region 542 and spatially confined N type region 544 formed in III-Nitride semiconductor body 540. P type region 542 and N type region 544 are spatially confined within III-Nitride semiconductor body 540, and can be selectively formed so as to be laterally adjacent or adjoining one another. As shown in Figure 5C, P type region 542 and N type region 544 are spatially confined within III-Nitride semiconductor body 540 and are buried to a predetermined depth beneath the top surface of III-Nitride semiconductor body 540.

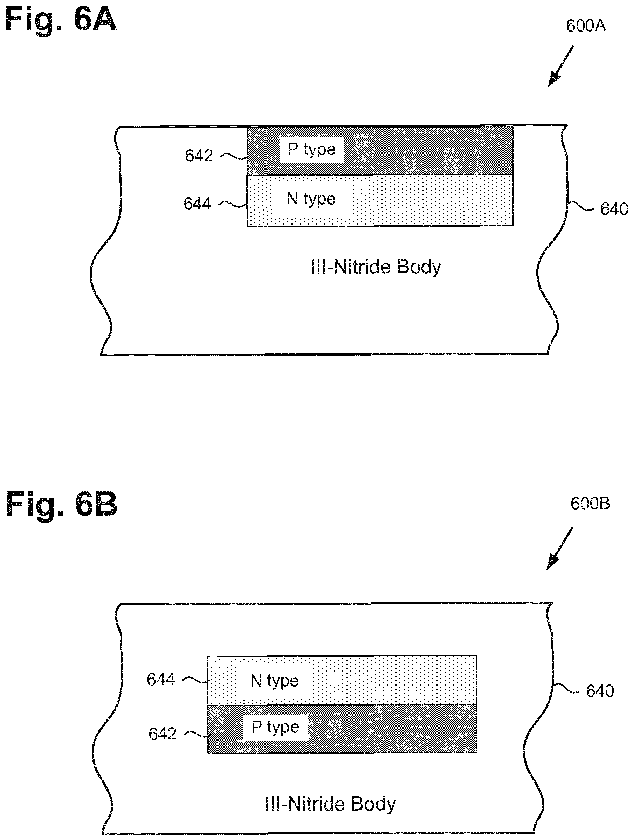

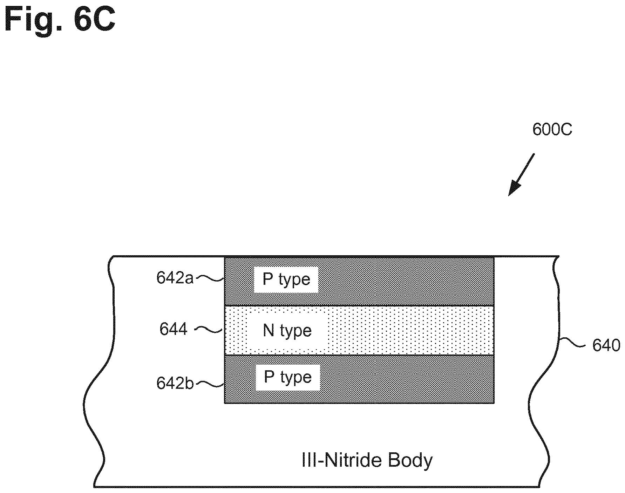

Moving to Figures 6A, 6B, and 6C, Figures 6A, 6B, and 6C show respective cross-sectional representations of vertically stacked P type and N type regions formed in a III-Nitride semiconductor body as a result of ion implantation at high temperature surface equilibrium conditions, according to various implementation. Structure 600A, in Figure 6A, includes spatially confined N type region 644 formed in III-Nitride semiconductor body 640, and spatially confined P type region 642 formed at or near a top surface of III-Nitride semiconductor body 640 and stacked over N type region 644. III-Nitride semiconductor body 640 corresponds in general to III-Nitride semiconductor body 140/240, shown in Figure 1/2, and may share any of the characteristics attributed to that corresponding feature, above.

Continuing to Figure 6B, structure 600B includes spatially confined N type region 644 formed in III-Nitride semiconductor body 640 and stacked over spatially confined P type region 642. As shown in Figure 5B, P type region 642 and N type region 644 are spatially confined within III-Nitride semiconductor body 640 and are buried to respective predetermined depths beneath the top surface of III-Nitride semiconductor body 640.

Although figures 6A and 6B depict formation of two different implanted regions spatially confined within III-Nitride semiconductor body 640 and stacked vertically on one another, it is noted that more than two spatially confined implanted regions may be formed, for example P-N-P and N-P-N vertically stacked arrangements. Figure 6C shows an example of a P-N-P structure. P type regions 642a and 642b, and N type region 644 are spatially confined within III-Nitride semiconductor body 640, and have been selectively formed so that N type region 644 is formed between P type region 642a and P type region 642b within III-Nitride semiconductor body 640. It is further noted that in such implementations, the upper doped region (e.g., P type region 642a, in Figure 6C) may be formed at or near the top surface of III-Nitride semiconductor body 640, or may be buried so as to be situated at a substantial depth beneath the the top surface of III-Nitride semiconductor body 640. Analogously, the lower doped region (e.g., P type region 642b, in Figure 6C) may be formed at or near a bottom surface of III-Nitride semiconductor body 640, or may be situated at a height substantially above the bottom surface.

Thus, the concepts disclosed by the present application enable laterally selective, spatially confined ion implantation of a III-Nitride semiconductor body at an elevated implantation temperature, while concurrently preserving the structural and stoichiometric properties of the semiconductor material. As a result, the present application discloses an approach that makes it possible to advantageously perform junction engineering in a III-Nitride semiconductor body. In addition, because the present inventive concepts may be applied to facilitate either N type or P type dopant implantation, the fabrication of bipolar or reduced surface field (RESURF) devices is rendered significantly easier to achieve.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A method comprising:
situating a III-Nitride semiconductor body in a surface equilibrium chamber configured to prevent an escape of nitrogen from said III-Nitride semiconductor body during implantation of said III-Nitride semiconductor body;
establishing a gas pressure greater than or equal to a surface equilibrium pressure sufficient to prevent said escape of nitrogen from said III-Nitride semiconductor body;
heating said III-Nitride semiconductor body to an implantation temperature in a range of 500°C to 1100°C in said surface equilibrium chamber while substantially maintaining said gas pressure above an exposed surface of said III-Nitride semiconductor body; said method comprising the following features:
implanting said III-Nitride semiconductor body in said surface equilibrium chamber at said elevated implantation temperature while maintaining said gas pressure in a range between 1.0 and 1000 mTorr;
wherein said implanting is performed using an ion implanter interfacing with said surface equilibrium chamber.

2. The method of claim 1, wherein said implanting results in formation of a laterally spatially confined doped region in said III-Nitride semiconductor body.

3. The method of claim 1, wherein dopants implanted into said III-Nitride semiconductor body are electrically activated without escape of nitrogen from a surface of said III-Nitride semiconductor body.

4. The method of claim 1, wherein said implanting results in formation of at least one of a spatially confined N type region and a spatially confined P type region in said III-Nitride semiconductor body.

5. The method of claim 1, wherein said implanting results in formation of a P-N junction in said III-Nitride semiconductor body.

## Patentansprüche

1. Verfahren, umfassend:
Anordnen eines III-Nitrid-Halbleiterkörpers in einer Oberflächenausgleichskammer, die dafür gestaltet ist, Entweichen von Stickstoff aus dem III-Nitrid-Halbleiterkörper während Implantation des III-Nitrid-Halbleiterkörpers zu verhindern;
Einrichten eines Gasdrucks von größer als ein oder gleich einem Oberflächenausgleichsdruck, der ausreicht, um das Entweichen von Stickstoff aus dem III-Nitrid-Halbleiterkörper zu verhindern;
Erhitzen des III-Nitrid-Halbleiterkörpers auf eine Implantationstemperatur in einem Bereich von 500 °C bis 1100 °C in der Oberflächenausgleichskammer, wobei der Gasdruck über einer freiliegenden Oberfläche des III-Nitrid-Halbleiterkörpers im Wesentlichen gehalten wird;
wobei das Verfahren folgende Elemente umfasst:
Implantieren des III-Nitrid-Halbleiterkörpers in der Oberflächenausgleichskammer bei der erhöhten Implantationstemperatur, wobei der Gasdruck in einem Bereich zwischen 1,0 und 1000 mTorr gehalten wird;
wobei das Implantieren unter Verwendung einer Ionenimplantationsvorrichtung durchgeführt wird, die mit der Oberflächenausgleichskammer gekoppelt ist.

2. Verfahren gemäß Anspruch 1, wobei die Implantation zu der Entstehung eines seitlich räumlich begrenzten dotierten Bereichs in dem III-Nitrid-Halbleiterkörper führt.

3. Verfahren gemäß Anspruch 1, wobei Dotierstoffe, die in den III-Nitrid-Halbleiterkörper implantiert werden, ohne Entweichen von Stickstoff aus einer Oberfläche des III-Nitrid-Halbleiterkörpers elektrisch aktiviert werden.

4. Verfahren gemäß Anspruch 1, wobei die Implantation zu der Entstehung wenigstens eines von einem räumlich begrenzten N-Typ-Bereich und einem räumlich begrenzten P-Typ-Bereich in dem III-Nitrid-Halbleiterkörper führt.

5. Verfahren gemäß Anspruch 1, wobei die Implantation zu der Entstehung eines P-N-Übergangs in dem III-Nitrid-Halbleiterkörper führt.

## Revendications

1. Procédé comprenant :
situer un corps semi-conducteur en nitrure III dans une chambre d'équilibre de surface configurée pour empêcher un dégagement d'azote du corps semi-conducteur de nitrure III pendant une implantation du corps semi-conducteur de nitrure III;
établir une pression gazeuse supérieure ou égale à une pression d'équilibre de surface suffisante pour empêcher le dégagement d'azote du corps semi-conducteur de nitrure III;
porter le corps de semi-conducteur de nitrure III à une température d'implantation dans une plage de 500°C à 1100°C dans la chambre d'équilibre de surface, tout en maintenant sensiblement la pression gazeuse au dessus d'une surface mise à nu du corps semi-conducteur de nitrure III;
le procédé comprenant les caractéristiques suivantes :
implanter le corps semi-conducteur de nitrure III dans la chambre d'équilibre de surface à la température d'implantation élevée, tout en maintenant la pression gazeuse dans une plage comprise entre 1,0 et 1000 mTorr;
dans lequel on effectue l'implantation en utilisant un implanteur d'ions en interface avec la chambre d'équilibre de surface.

2. Procédé suivant la revendication 1, dans lequel l'implantation se traduit par la formation d'une région dopée confinée spatialement latéralement dans le corps semi-conducteur de nitrure III.

3. Procédé suivant la revendication 1, dans lequel on active électriquement des agents de dopage implantés dans le corps semi-conducteur de nitrure III sans dégagement d'azote d'une surface du corps semi-conducteur de nitrure III.

4. Procédé suivant la revendication 1, dans lequel l'implantation se traduit par la formation d'au moins une région de type N confinée spatialement et une région de type P confinée spatialement dans le corps semi-conducteur de nitrure III.

5. Procédé suivant la revendication 1, dans lequel l'implantation se traduit par la formation d'une jonction P-N dans le corps semi-conducteur de nitrure III.
